# FASCICULE DE BREVET EUROPEEN

(11) **EP 4 554 094 B1**
(45) Date de publication et mention de la délivrance du brevet: **15.07.2026**
(21) Numéro de dépôt: 24209513.1
(22) Date de dépôt: 29.10.2024
(51) Int. Cl.: H03K 17/16, H02M 1/00, H02M 1/08

(54) **PUCE ELECTRONIQUE CONNECTEE A UNE TENSION EXTERNE**
ELEKTRONISCHER CHIP, DER MIT EINER EXTERNEN SPANNUNG VERBUNDEN IST
ELECTRONIC CHIP CONNECTED TO EXTERNAL VOLTAGE

(30) Priorité: 09.11.2023 FR 2312255
(43) Date de publication de la demande: 14.05.2025
(73) Titulaire: STMicroelectronics International N.V., 1228 Plan-les-Ouates, Geneva (CH)
(72) Inventeur: CIMAZ, Lionel, 35137 Pleumeleuc (FR)
(74) Mandataire: Cabinet Beaumont

(56) Documents cités:
- EP-A2- 0 777 309
- WO-A1-00/27032
- DE-T5- 112021 006 668
- US-A1- 2018 316 344
- US-A1- 2019 158 083

## Description

### Domaine technique

La présente description concerne de façon générale les circuits électroniques intégrés, et, plus particulièrement, les puces de circuit intégré connectées à une tension d'alimentation externe à la puce ("off-chip" en anglais) par un fil conducteur, c'est à dire par une liaison par fil ("wire bonding" en anglais).

### Technique antérieure

De nombreuses puces de circuit intégré connues, par exemple les puces des documents WO 00/27032 A1, US 2018/316344 A1 et US 2019/158083 A1, comprennent un plot de connexion ("connection pad" en anglais) configuré pour être connecté à une tension d'alimentation externe à la puce par un fil conducteur et un autre plot de connexion configuré pour être connecté à une tension de référence par un autre fil conducteur.

Certaines de ces puces connues comprennent un transistor PMOS utilisé en interrupteur, par exemple en interrupteur de côté haut ("high side switch" en anglais) d'un convertisseur continu-continu à découpage ("DC-DC SMPS" ou "DC-DC Switched Mode Power Supply" en anglais). Cet interrupteur PMOS couple un noeud interne de la puce, lui-même relié à une charge, au plot de connexion qui est connecté à la tension d'alimentation. En outre, ces puces comprennent une capacité de découplage couplant les deux plots de connexion entre eux.

Ces puces connues comprenant un transistor PMOS tel que décrit ci-dessus présentent divers inconvénients.

### Résumé de l'invention

Il existe un besoin de pallier tout ou partie des inconvénients des puces de circuit intégré telles que décrites précédemment.

Par exemple, il existe un besoin, lors de la commutation à l'état ouvert du transistor PMOS de ces puces, de limiter, voire d'éviter, des oscillations de tension sur la source du transistor PMOS résultant de l'inductance parasite du fil conducteur couplant la tension d'alimentation au plot de connexion correspondant de la puce.

Un mode de réalisation pallie tout ou partie des inconvénients des puces de circuit intégré connues, et, plus particulièrement des puces de circuit intégré connues telles que décrites précédemment.

Un mode de réalisation prévoit une puce de circuit intégré comprenant :
- un premier plot de connexion destiné à être couplé à une tension d'alimentation externe par un premier fil conducteur ;
- un deuxième plot de connexion destiné à être couplé à une tension de référence externe par un deuxième fil conducteur ;
- un transistor PMOS couplant le premier plot à un noeud interne de la puce configuré pour être connecté à une charge ;
- une capacité de découplage couplant les premier et deuxième plots entre eux ;
- un premier circuit de détection configuré pour détecter une augmentation, par exemple au-dessus d'un premier seuil, d'une résistance source/drain du transistor PMOS ;
- un deuxième circuit de détection (DET3) configuré pour détecter que le transistor PMOS (HS) est à l'état bloqué en comparant un courant dans le transistor PMOS à un seuil de courant ; et
- un premier circuit de commande configuré, lors de chaque commutation à l'état bloqué du transistor PMOS, pour fournir un premier courant à la grille du transistor PMOS courant si le deuxième circuit de détection (DET3) détecte que le transistor PMOS est bloqué ou si le premier circuit de détection (DET1) ne détecte pas une augmentation de la résistance source/drain, et pour fournir un deuxième courant plus faible que le premier courant sinon.

Selon un mode de réalisation, la puce de circuit intégré comprend en outre une diode couplant le noeud interne au deuxième plot, l'anode de la diode étant du côté du deuxième plot.

Selon un mode de réalisation, le noeud interne est couplé, de préférence connecté, à un troisième plot de connexion de la puce, le troisième plot étant destiné à être connectée une inductance externe par un troisième fil conducteur, l'inductance externe faisant partie de la charge.

Selon un mode de réalisation, la puce de circuit intégré comprend en outre un circuit de protection contre les décharges électrostatiques couplant les premier et deuxième plots entre eux.

Selon un mode de réalisation, le premier circuit de détection comprend un comparateur configuré pour comparer la tension de source du transistor PMOS à la tension de drain du transistor PMOS majorée par une tension de seuil du premier circuit de détection, et pour fournir un signal binaire indiquant un résultat de la comparaison.

Selon un mode de réalisation, la puce de circuit intégré comprend en outre un deuxième circuit de commande configuré pour fournir un premier signal binaire au premier circuit de commande, un premier état binaire du premier signal commandant l'état bloqué du transistor PMOS et un deuxième état binaire du premier signal commandant un état passant du transistor PMOS.

Selon un mode de réalisation, la puce de circuit intégré comprend en outre :
- un transistor NMOS couplant le noeud interne au deuxième plot ; et
- un troisième circuit de commande configuré pour commander le transistor NMOS,
le deuxième circuit de commande étant configuré pour fournir un deuxième signal binaire au troisième circuit de commande, un premier état binaire du deuxième signal commandant l'état bloqué du transistor NMOS et un deuxième état binaire du deuxième signal commandant un état passant du transistor NMOS.

Selon un mode de réalisation :
- la puce de circuit intégré comprend en outre un troisième circuit de détection configuré pour détecter lorsqu'une tension du noeud interne est proche d'une valeur nulle, par exemple en comparant ladite tension à un deuxième seuil ; et
- le deuxième circuit de commande est configuré pour commuter le deuxième signal à son deuxième état binaire quand le troisième circuit de détection détecte que la tension du noeud interne est proche de la valeur nulle.

Selon un mode de réalisation, le troisième circuit de détection comprend un comparateur configuré pour comparer la tension du noeud interne à la tension du deuxième plot majorée par une tension de seuil du troisième circuit de détection, et pour fournir un signal binaire indiquant un résultat de la comparaison.

Selon un mode de réalisation, le deuxième circuit de commande est configuré pour commuter le deuxième signal à son deuxième état binaire dès que le troisième circuit de détection détecte que la tension du noeud interne est proche de la valeur nulle ou que le deuxième circuit de détection détecte que le transistor PMOS est à l'état bloqué.

Selon un mode de réalisation, le deuxième circuit de détection comprend :
un transistor PMOS supplémentaire monté en miroir du transistor PMOS et ayant son drain couplé au deuxième plot par une résistance ou une source de courant constant ; et
un comparateur configuré pour comparer la tension de source du transistor PMOS supplémentaire à un seuil et pour fournir un signal binaire indiquant le résultat de la comparaison.

Selon un mode de réalisation, le transistor PMOS est un transistor de côté haut d'un convertisseur DC-DC à découpage.

Un autre mode de réalisation prévoit un dispositif électronique, dans lequel le dispositif comprend :
- la puce de circuit intégré décrite ci-dessus ;
- une source de la tension d'alimentation disposée à l'extérieur de la puce et couplée au premier plot de la puce par le premier fil conducteur ;
- une source de la tension de référence disposée à l'extérieur de la puce et couplée au deuxième plot de la puce par le deuxième fil conducteur.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, au moins en partie sous la forme de blocs, un exemple d'un dispositif électronique ;
la figure 2 représente, au moins en partie sous la forme de blocs, un exemple de mode de réalisation d'un dispositif électronique (non couvert par les revendications) ;
la figure 3 représente, au moins en partie sous la forme de blocs, un exemple de variante de réalisation du dispositif électronique de la figure 2 (non couvert par les revendications) ;
la figure 4 représente, au moins en partie sous la forme de blocs, un exemple d'une autre variante de réalisation du dispositif électronique de la figure 2 ;
la figure 5 représente un exemple de mode de réalisation d'un circuit du dispositif des figures 2, 3 et 4 ;
la figure 6 représente un exemple de mode de réalisation d'un circuit du dispositif des figures 3 et 4 ; et
la figure 7 représente un exemple de mode de réalisation d'un circuit du dispositif de la figure 4.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

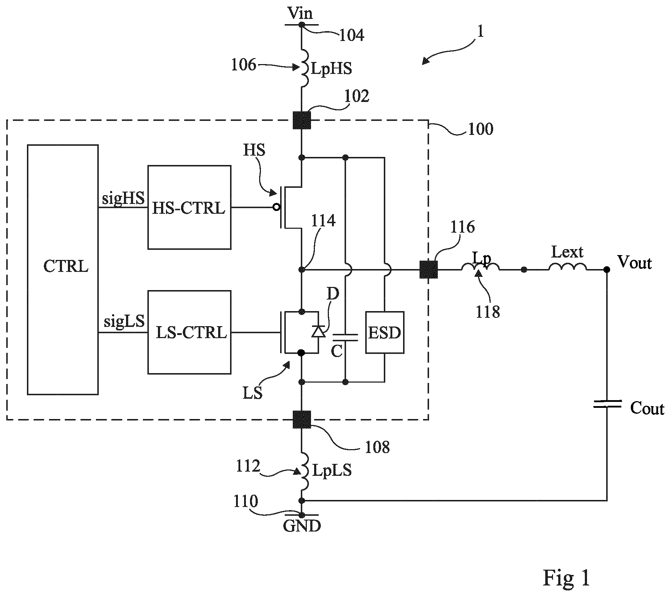

La figure 1 représente, au moins en partie sous la forme de blocs, un exemple d'un dispositif ou système électronique 1.

Le dispositif 1 comprend un puce de circuit intégré 100, délimitée en traits pointillés en figure 1.

La puce 100 comprend un plot de connexion 102. Le plot 102 est destiné à être connecté à une tension d'alimentation Vin, la tension Vin étant, par exemple, une tension continue (DC de l'anglais "Direct Current") et étant, par exemple, positive par rapport une tension continue de référence GND, par exemple la masse. Plus particulièrement, le plot 102 est destiné à être connecté à la tension d'alimentation Vin, c'est à dire à un plot 104 du dispositif 1 qui est externe à la puce 100 et qui est à la tension Vin, par un fil conducteur 106 représenté en figure 1 par son inductance parasite LpHS.

La puce 100 comprend en outre un plot de connexion 108. Le plot 108 est destiné à être connecté à la tension de référence GND. Plus particulièrement, le plot 108 est destiné à être connecté à la tension GND, c'est à dire à un plot 110 du dispositif 1 qui est externe à la puce 100 et qui est à la tension GND, par un fil conducteur 112 représenté en figure 1 par son inductance parasite LpLS.

La puce 100 comprend en outre un transistor PMOS (de l'anglais "P Metal Oxide Semiconductor transistor" - transistor métal oxide semiconducteur à canal P), référencé HS en figure 1. Le transistor HS couple le plot 102 à un noeud interne 114 de la puce 100. Par exemple, la source du transistor HS est couplée, de préférence connectée, au plot 102, et le drain du transistor HS est couplé, de préférence connecté, au noeud 114. Le transistor HS est utilisé (commandé) en interrupteur.

Le noeud 114 est destiné à être couplé à une charge. Dans l'exemple de la figure 1, le noeud 114 est couplé, de préférence connecté, à un plot de connexion 116 de la puce, le plot 116 étant destiné à être connecté à tout ou partie de la charge, par un fil conducteur 118 représenté par son inductance parasite Lp en figure 1. Plus particulièrement, dans l'exemple de la figure 1, la charge comprend une inductance Lext externe à la puce 100, l'inductance Lext ayant une première borne connectée au fil 118 pour être couplée au noeud 114, et une deuxième borne couplée à la tension GND, c'est à dire au plot 110, par une charge à alimenter comprenant une capacité Cout (seule la capacité Cout de la charge à alimenter est représentée en figure 1). Dans cet exemple où le dispositif 1 est un convertisseur DC-DC à découpage, la capacité Cout permet de maintenir, une fois qu'elle chargée, une tension Vout sur le noeud de connexion de l'inductance Lext à la capacité Cout.

La puce comprend en outre une capacité C couplant les plots 102 et 108 entre eux. Par exemple, la capacité C a une première borne ou électrode couplée, de préférence connectée, au plot 102, et une deuxième borne ou électrode couplée, de préférence connectée, au plot 108.

Le noeud 114 est en outre couplé au plot 108 par une diode D de la puce 100, la diode D ayant son anode du côté du plot 108. Par exemple, la diode D a son anode couplée, de préférence connectée, au plot 108, et sa cathode couplée, de préférence connectée, au noeud 114.

Dans l'exemple de la figure 1, l'interrupteur HS est l'interrupteur de côté haut ("high side switch" en anglais) d'un convertisseur DC-DC à découpage, le convertisseur étant un convertisseur abaisseur ("buck converter" en anglais). La diode D correspond à la diode de roue libre du convertisseur.

Dans l'exemple de la figure 1 où l'interrupteur HS fait partie d'un convertisseur DC-DC à découpage, la puce 100 comprend en outre un transistor NMOS (de l'anglais "N Metal Oxide Semiconductor transistor" - transistor métal oxide semiconducteur à canal N), référencé LS en figure 1. Le transistor LS couple le noeud 114 au plot 108. Par exemple, la source du transistor LS est couplée, de préférence connectée, au plot 108, et le drain du transistor LS est couplé, de préférence connecté, au noeud 114. Le transistor LS est utilisé (commandé) en interrupteur. A titre d'exemple, la diode D correspond à la diode de corps ("body diode" en anglais) du transistor LS. A titre d'autre exemple, la diode D est connectée en parallèle du transistor LS. A titre d'autre exemple, le transistor LS peut être omis.

De manière optionnelle, la puce 100 comprend un circuit ESD de protection contre les décharges électrostatiques, couplant entre eux les plots 102 et 108. Le circuit ESD est configuré pour être passant, c'est à dire pour permettre le passage d'un courant du plot 102 au plot 108, lorsque la différence de tension entre les plots 102 et 108 dépasse un seuil, et bloqué sinon.

La puce 100 comprend un circuit de commande HS-CTRL du transistor HS. Le circuit HS-CTRL commande la grille du transistor HS de sorte à commander l'état passant ou bloqué du transistor HS. Par exemple, lorsque le circuit HS-CTRL commande une commutation de l'état passant à l'état bloqué du transistor HS, ce circuit HS-CTRL fournit un courant constant à la grille du transistor HS, qui se décharge jusqu'à ce que la tension grille-source du transistor HS soit inférieure au seuil de mise en conduction du transistor HS et que ce dernier soit à l'état bloqué, empêchant ainsi le passage d'un courant du plot 102 au noeud 114. A l'inverse, lorsque le circuit HS-CTRL commande une commutation de l'état bloqué à l'état passant du transistor HS, ce circuit HS-CTRL tire un courant constant sur la grille du transistor HS, qui se charge jusqu'à ce que la tension grille-source du transistor HS soit supérieure au seuil de mise en conduction du transistor HS et que ce dernier soit à l'état passant, permettant ainsi le passage d'un courant du plot 102 au noeud 114.

A titre d'exemple, le circuit HS-CTRL reçoit un signal binaire sigHS indiquant par son premier état binaire que le circuit HS-CTRL doit commander le transistor HS à l'état bloqué, et par son deuxième état binaire que le circuit HS-CTRL doit commander le transistor HS à l'état passant.

A titre d'exemple, le signal sigHS est fourni par un circuit de commande CTRL faisant partie de la puce 100.

Dans des exemples où la puce 100 comprend le transistor LS, la puce 100 comprend un circuit de commande LS-CTRL du transistor LS. Le circuit LS-CTRL commande la grille du transistor LS de sorte à commander l'état passant ou bloqué du transistor LS. Par exemple, lorsque le circuit LS-CTRL commande une commutation de l'état passant à l'état bloqué du transistor LS, ce circuit LS-CTRL tire un courant constant sur la grille du transistor LS, qui se décharge jusqu'à ce que la tension grille-source du transistor LS soit inférieure au seuil de mise en conduction du transistor LS et que ce dernier soit à l'état bloqué, empêchant ainsi le passage d'un courant du plot 108 au noeud 114. A l'inverse, lorsque le circuit LS-CTRL commande une commutation de l'état bloqué à l'état passant du transistor LS, ce circuit LS-CTRL fournit un courant constant à la grille du transistor LS, qui se charge jusqu'à ce que la tension grille-source du transistor LS soit supérieure au seuil de mise en conduction du transistor LS et que ce dernier soit à l'état passant, permettant ainsi le passage d'un courant du plot 108 au noeud 114.

A titre d'exemple, le circuit LS-CTRL reçoit un signal binaire sigLS indiquant par son premier état binaire que le circuit LS-CTRL doit commander le transistor LS à l'état bloqué, et par son deuxième état binaire que le circuit LS-CTRL doit commander le transistor LS à l'état passant.

A titre d'exemple, le signal sigLH est fourni par le circuit CTRL.

Dans le dispositif 1 de la figure 1, lorsque l'interrupteur HS est passant et que l'interrupteur LS, s'il est présent, est bloqué, un courant circule depuis le plot 104 jusqu'au plot 110, par l'intermédiaire successivement du fil 106, du transistor HS, du fil 118, de l'inductance Lext et de la charge à alimenter Cout.

Lorsque le transistor HS est alors commuté à l'état bloqué, ce courant ne peut plus circuler dans le transistor HS. Toutefois, comme le courant dans une inductance ne présente pas de discontinuité, le courant qui circulait dans l'inductance parasite LpHS cherche un chemin conducteur jusqu'au plot 110. Ce courant circule alors jusqu'au plot 108 via la capacité C, puis jusqu'au noeud 114 via la diode D ou le transistor LS si celui-ci est passant, puis jusqu'au plot 110 via le fil 118, l'inductance Lext et la charge à alimenter Cout. En effet, ce courant ne peut pas circuler jusqu'au plot 110 via le fil 112 du fait que, au moment de la commutation à l'état bloqué du transistor HS, le courant dans l'inductance LpLS est nul et que le courant dans l'inductance LpLS ne peut pas présenter de discontinuité.

Dans ce cas, l'inductance LpHS, la capacité C et l'inductance Lp forment un circuit LC résonnant entre le plot 104 et l'inductance Lext. En outre, la tension Vin est constante et la tension sur le plot 116 varie peu en raison du fait que, en pratique, l'inductance Lext a des valeurs très supérieures, par exemple au moins 10 fois supérieure, à celle de l'inductance parasite LpHS et celle de l'inductance parasite Lp. Il en résulte des oscillations de la tension sur le plot 102.

Ces oscillations atteignent des valeurs maximales pouvant détériorer, voire détruire, le transistor HS et les autres transistors PMOS (non représentés) de la puce 100 qui sont connectés au plot 102.

Lorsqu'il est présent, le circuit ESD est déclenché par l'augmentation de la tension entre les plots 102 et 108 et vient court-circuiter la capacité C, ce qui permet d'éviter les oscillations. Toutefois, ce dispositif ESD n'est pas prévu pour se déclencher à chaque commutation à l'état bloqué du transistor HS, et va donc vieillir plus rapidement.

En outre, si le circuit ESD est mis en œuvre à partir de composants de type SCR (de l'anglais "Silicium Controlled Rectifier" - redresseur silicium commandé), le circuit ESD peut, une fois déclenché, rester enclenché tant que la tension entre les plots 102 et 108 ne s'annule pas, et venir alors empêcher le bon fonctionnement de la puce 100, par exemple du convertisseur à découpage comprenant le transistor HS.

A titre d'exemple, pour une tension Vin égale à 3 V, des fils 106, 112 et 118 présentant chacun une inductance parasite de 4 nH et une résistance parasite de 50 mOhms, une capacité C de 10 pF, et un courant de 0,4 A dans l'inductance parasite LpHS au moment où l'interrupteur HS est commuté à l'état bloqué, la tension sur le plot 102, sensiblement égale à 3 V avant la commutation de l'interrupteur HS, présente un pic à 5,5 V, seulement 1,6 ns après la commutation.

Augmenter la valeur de la capacité C permet de réduire l'amplitude des oscillations. Toutefois, augmenter la valeur de la capacité C pour rendre l'amplitude des oscillations acceptable pour les transistors MOS connectés au plot 102 entraîne une augmentation importante de la surface de la puce 100, ce qui n'est pas souhaitable. En reprenant l'exemple numérique ci-dessus, augmenter la valeur de la capacité C de 10 pF à 1000 pF réduit le pic de tension sur le plot 102 à 4,06 V, mais la surface de capacité C est alors 100 fois plus importante, et devient du même ordre de grandeur que la surface occupée par le convertisseur sur la puce 100.

Diminuer la valeur de l'inductance parasite LpHS et de celle de l'inductance parasite Lp permet de réduire l'amplitude des oscillations. Toutefois, il n'est pas toujours possible de réduire la valeur de ces inductances parasites. C'est par exemple le cas lorsque la puce 100 est produite par une première entité, et assemblée par une deuxième entité sur un support auquel la puce 100 est connectée par les fils 106, 112 et 118.

En pratique, lors de la commutation d'un transistor PMOS à l'état bloqué, il y a une première phase où la grille du transistor se décharge et où la tension grille-source du transistor diminue (en valeur absolue) avec une pente proportionnelle au courant fourni à la grille du transistor par son circuit de commande, sans que la résistance source-drain du transistor ne change. Puis, la tension grille-source du transistor atteint un plateau correspondant à une seconde phase pendant laquelle les porteurs qui étaient accumulés sous la grille du transistor sont supprimés sans que la résistance source-drain ne change de manière significative, la durée du plateau étant déterminée par le courant fourni à la grille du transistor par son circuit de commande. Enfin, à la fin de ce plateau, lors d'une troisième phase, la tension grille-source du transistor diminue de nouveau (en valeur absolue) avec une pente proportionnelle au courant fourni à la grille du transistor par son circuit de commande, et la résistance entre la source et le drain du transistor augmente avec la variation de la tension grille-source, jusqu'à ce que cette résistance soit assez élevée pour que le transistor soit à l'état bloqué. Le temps de commutation du transistor est alors égal au temps total correspondant à la succession des première, deuxième et troisième phases, et le transistor reste passant pendant 4/5 du temps de commutation.

Bien que cela ne soit pas détaillé, le transistor PMOS présente un comportement symétrique lors d'une commutation à l'état passant, où le transistor reste bloqué 4/5 du temps de commutation à l'état passant, et les transistors NMOS ont, eux aussi, un comportement similaire.

En diminuant le courant fourni à la grille du transistor HS par le circuit pendant les première, deuxième et troisièmes phases successives de la commutation du transistor HS à l'état bloqué, il en résulterait une augmentation de la durée de chacune de ces trois phases, et donc, lors de la troisième phase, une diminution correspondante de la vitesse à laquelle la résistance source-drain du transistor HS augmente. Cela pourrait permettre de décharger, pendant la troisième phase, l'inductance LpHS de sorte que le courant y soit nul lorsque le transistor HS commute effectivement à l'état bloqué. Toutefois, cela augmenterait également la durée des première et deuxième phase, et donc la durée totale de la commutation du transistor HS à l'état bloqué, ce qui n'est pas souhaitable. En effet, dans de nombreuses applications, on cherche généralement à réduire la durée totale de chaque commutation entre les états bloqué et passant des interrupteurs.

Par exemple, dans un convertisseur DC-DC à découpage, il est souhaitable que le temps de commutation de chacun des interrupteurs HS et LS représente moins de 1/20 de la durée totale d'un cycle de fonctionnement du convertisseur. Pour un convertisseur DC-DC ayant une fréquence de fonctionnement de 5 MHz, c'est à dire un temps de cycle de fonctionnement de 200 ns, cela signifie que le temps de commutation de chacun des interrupteurs LS et HS de 10 ns, et que la durée des troisièmes phases décrites ci-dessus doit être de 2 ns. En reprenant l'exemple numérique précédant, pour réduire l'amplitude des oscillations sur le plot 102 à des valeurs acceptables, il faudrait, par exemple, que la durée de chaque troisième phase soit supérieure ou égale à 25 fois L.I/Vin, avec L la valeur valeur d'inductance de l'inductance parasite LpHS, I le courant de 0,4 A dans l'inductance LpHS au moment de la commutation, et Vin égale à 3,3 V. Cela conduit à une durée de troisième phase d'au moins 13 ns, donc à une durée totale de commutation d'au moins 65 ns, ce qui n'est pas compatible avec une durée de cycle de fonctionnement de 10 ns.

Il est ici proposé, lors de la commutation du transistor HS à l'état bloqué de lui fournir un premier courant pendant les première et deuxième phases de la commutation, et un deuxième courant pendant la troisième phase de commutation. En prévoyant que le premier courant soit plus élevé que le deuxième courant, cela permet que les première et deuxième phases de la commutation soient rapides par rapport à la troisième phase qui sera plus lente. Il est alors possible de maintenir un temps total de commutation à l'état bloqué compatible avec une fréquence de fonctionnement donnée, en assurant une décharge complète de l'inductance LpHS au moment où le transistor HS commute effectivement à l'état bloqué, ce qui permet de réduire, voire supprimer, les oscillations sur le plot 102 sans devoir modifier les valeurs des inductances parasites et la valeur de la capacité C.

A titre d'exemple, la troisième phase peut alors être suffisamment lente pour que l'inductance LpHS se décharge complètement avant que le transistor HS ne bascule effectivement à l'état bloqué, tout en conservant des première et deuxième phases suffisamment rapides pour que la durée totale de la commutation, c'est à dire la durée totale des première, deuxième et troisième phases, soit compatible avec une fréquence de fonctionnement visée du convertisseur DC-DC.

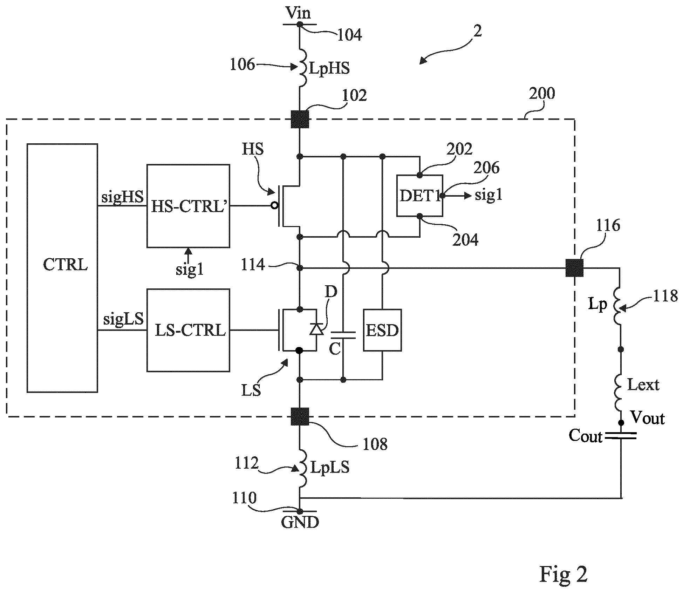

La figure 2 représente, au moins en partie sous la forme de blocs, un exemple de mode de réalisation d'un dispositif électronique 2.

Le dispositif 2 diffère du dispositif 1 de la figure 1 en ce que la puce 100 y est remplacée par une puce 200.

La puce 200 est similaire à la puce 100, et seules les différences entre ces deux puces sont ici mises en exergue. Ainsi, sauf indication contraire, tout ce qui a été indiqué pour la puce 100 s'applique à la puce 200.

En particulier, la puce 200 diffère de la puce 100 en ce que :
- le circuit HS-CTRL est remplacé par un circuit HS-CTRL' ; et
- la puce 200 comprend un circuit de détection DET1.

Le circuit DET1 est configuré pour détecter lorsque la résistance source-drain, par exemple appelée résistance à l'état passant, du transistor HS augmente.

De préférence, le circuit DET1 est configuré pour détecter lorsque la résistance drain-source du transistor HS dépasse une valeur seuil.

A titre d'exemple, cette valeur seuil est déterminée de sorte que, lors d'une commutation à l'état bloqué du transistor HS, la résistance source-drain du transistor HS devient supérieure à cette valeur seuil quand le transistor passe de la deuxième phase de la commutation (plateau) à la troisième phase de la commutation (augmentation de la résistance à l'état passant).

A titre d'exemple, le circuit DET1 fournit un signal binaire sig1 indiquant par un premier état binaire que la résistance source-drain du transistor HS n'est pas en train d'augmenter, c'est à dire par exemple que cette résistance drain-source est inférieure à la valeur seuil et correspond à l'état passant du transistor HS, et par un deuxième état binaire que la résistance drain-source du transistor HS est en train d'augmenter, c'est à dire par exemple que cette résistance drain-source est supérieure à la valeur seuil et que le transistor est dans la troisième phase de sa commutation à l'état bloqué. Le signal sig1 est par exemple disponible sur une sortie 206 du circuit DET1.

A titre d'exemple, le circuit DET1 comprend une entrée 202 connectée à la source du transistor HS et une entrée 204 connectée au drain du transistor HS.

A titre d'exemple, le circuit DET1 est configuré pour comparer la tension drain-source du transistor HS à un seuil, la tension drain-source du transistor HS étant supérieure au seuil lorsque la résistance drain-source du transistor HS est supérieure à la valeur seuil indiquant que le transistor HS est dans la troisième phase d'une commutation à l'état bloqué, et la tension drain-source du transistor HS étant inférieure au seuil lorsque la résistance drain-source du transistor HS est inférieure à la valeur seuil indiquant que le transistor HS est passant et dans la deuxième ou première phase d'une commutation à l'état bloqué.

Le circuit de commande HS-CTRL' du transistor HS est, comme le circuit HS-CTRL, configuré pour commander la grille du transistor HS de sorte à commander l'état passant ou bloqué du transistor HS. A titre d'exemple, le circuit HS-CTRL' reçoit un signal binaire sigHS indiquant par son premier état binaire que le circuit HS-CTRL doit commander le transistor HS à l'état bloqué, et par son deuxième état binaire que le circuit HS-CTRL doit commander le transistor HS à l'état passant. A titre d'exemple, le signal sigHS est fourni par un circuit de commande CTRL faisant partie de la puce 200.

Toutefois, par rapport au circuit HS-CTRL, le circuit HS-CTRL' reçoit du circuit DET1 une indication que la résistance source-drain du transistor HS est ou non en train d'augmenter. Par exemple, le circuit HS-CTRL' reçoit le signal sig1.

Dans cet exemple de mode de réalisation, le circuit HS-CTRL' est configuré, lors de chaque commutation à l'état bloqué du transistor HS, pour fournir un premier courant à la grille du transistor HS jusqu'à ce que le circuit DET1 détecte une augmentation de la résistance source/drain du transistor HS, et pour fournir ensuite un deuxième courant plus faible que le premier courant. Dit autrement, le circuit HS-CTRL' est configuré, lors de chaque commutation du transistor HS à l'état bloqué, pour fournir le premier courant pendant les première et deuxième phases de la commutation où le transistor HS est toujours passant, puis pour fournir le deuxième courant pendant la troisième phase où la résistance drain-source du transistor HS augmente jusqu'à ce que le transistor soit effectivement à l'état bloqué.

A titre d'exemple, le fonctionnement décrit ci-dessus du circuit HS-CTRL' correspond au fonctionnement du circuit HS-CTRL' lorsque le signal sigHS commute à son premier état binaire, jusqu'à ce que le signal sigHS commute de nouveau à son deuxième état binaire.

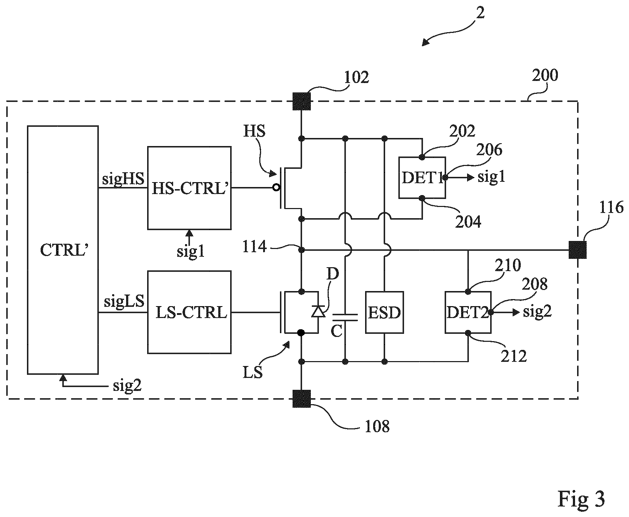

La figure 3 représente, au moins en partie sous la forme de blocs, un exemple de variante de réalisation du dispositif 2 de la figure 2.

Seules les différences entre le dispositif 2 de la figure 2 et celui de la figure 3 sont ici mises en exergue. Ainsi, sauf indication contraire, tous ce qui a été indiqué pour le dispositif 2 de la figure 2 s'applique au dispositif 2 de la figure 3. En figure 3, seule la puce 200 du dispositif 2 est représentée.

En particulier, le dispositif 2 de la figure 3 diffère de celui de la figure 2 en ce que :
- la puce 200 comprend un circuit de détection DET2 ; et
- le circuit CTRL y est remplacé par un circuit CTRL'.

En outre, dans cette variante, la puce 200 comprend le transistor LS, et les transistors HS et LS sont commandés de sorte que l'ensemble des transistors HS et LS et de l'inductance Lext mettent en œuvre un convertisseur DC-DC à découpage, fonctionnant en modulation de largeur d'impulsion (PWM de l'anglais "Pulse Width Modulation") et/ou en modulation de fréquence d'impulsion (PFM de l'anglais "Pulse Frequency Modulation"). De préférence, le convertisseur 2 est de type abaisseur.

Dans des convertisseurs usuels du type de celui décrit en relation avec la figure 1, lors d'une commutation du transistor HS à l'état bloqué, le transistor LS n'est commuté à l'état passant qu'après la commutation à l'état bloqué du transistor HS, c'est à dire après la fin de la troisième phase de cette commutation.

Dans le cas des puces 200 décrites ici, l'augmentation de la résistance source-drain du transistor HS pendant la troisième phase de chaque commutation à l'état passant de ce transistor HS est plus lente du fait du deuxième courant plus faible que le premier courant pour permettre de décharger l'inductance LpHS avant la fin de la commutation à l'état bloqué. Il en résulte que, bien que le transistor HS ne soit pas encore effectivement à l'état bloqué et soit encore dans la troisième phase de la commutation, la résistance source-drain du transistor HS et le courant qui circule entre la source et le drain du transistor HS peuvent avoir des valeurs telles que la tension du noeud 114 devienne suffisamment négative, par exemple inférieure ou égale à -0,7 V, pour que la diode D se mette à conduire, ce qui provoque des pertes non désirées dans la diode D.

Pour éviter la mise en conduction non désirée de la diode D, le circuit DET2 est configuré pour détecter lorsque la tension du noeud 114 est proche de la valeur de la tension de référence GND mais encore supérieure à cette dernière, c'est à dire pour détecter lorsque la tension du noeud 114 est encore positive mais proche d'une valeur nulle.

De préférence, le circuit DET2 est configuré pour détecter lorsque la tension 114 devient inférieure à une tension de seuil. Dit autrement, lorsque la tension du noeud 114 diminue pendant une commutation à l'état bloqué du transistor HS, elle est considérée comme étant proche d'une valeur nulle si elle devient inférieure à cette tension de seuil. A titre d'exemple, cette tension de seuil du circuit DET2 est comprise entre Vin/10 et 0 V.

A titre d'exemple, le circuit DET2 fournit un signal binaire sig2 indiquant par un premier état binaire que la tension du noeud 114 est proche de la valeur nulle, c'est à dire par exemple que cette tension est inférieure à la tension de seuil, et par un deuxième état binaire que la tension du noeud 114 est éloignée de la valeur nulle, c'est à dire par exemple que cette tension est supérieure à la tension de seuil. Le signal sig2 est par exemple disponible sur une sortie 208 du circuit DET2.

A titre d'exemple, le circuit DET2 comprend une entrée 210 connectée au noeud 114, et une entrée 212 connectée au plot 108.

En outre, il est prévu, lorsque le circuit DET2 indique que la tension du noeud 114 est proche d'une valeur nulle, pour commuter le transistor LS à l'état passant. Ainsi, le transistor LS est commuté à l'état passant avant que la tension du noeud 114 ne deviennent négative et atteigne des valeurs propres à mettre la diode D en conduction.

Pour cela, le circuit CTRL' est similaire au circuit CTRL mais diffère de ce dernier en ce que :
- le circuit CTRL' reçoit du circuit DET2 l'indication que la tension du noeud 114 est ou non proche d'une valeur nulle, par exemple le circuit CTRL' reçoit le signal sig2 ; et
- le circuit CTRL' commande une commutation du transistor LS à l'état passant, c'est à dire que le circuit CTRL' commute le signal sigLS à son deuxième état binaire, dès que le circuit DET2 détecte que la tension du noeud 114 est proche d'une valeur nulle, bien que la commutation à l'état bloqué du transistor HS puisse ne pas être terminée.

Ainsi, le transistor LS sera passant avant que la tension du noeud 114 n'atteigne des valeurs propres à mettre la diode D en conduction, et le courant circulera par le transistor LS passant plutôt que par la diode D plus résistive, ce qui limite les pertes.

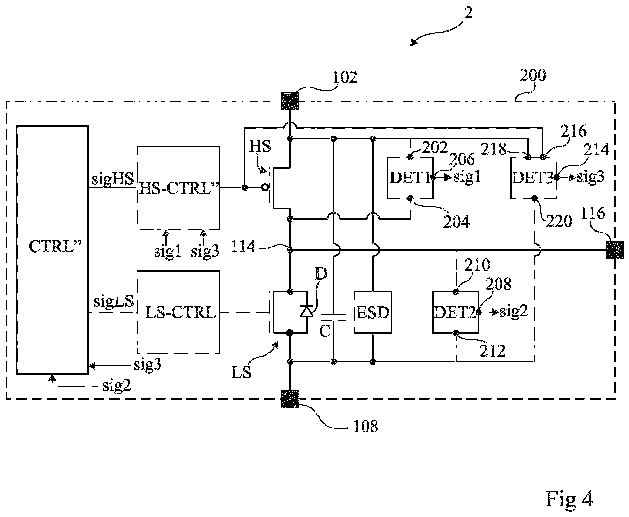

La figure 4 représente, au moins en partie sous la forme de blocs, un exemple d'une autre variante de réalisation du dispositif électronique 2 de la figure 2.

Le dispositif électronique 2 de la figure 4 comprend de nombreux éléments en commun avec celui de la figure 3, et seules les différences entre ces deux dispositifs sont ici mises en exergue. Ainsi, sauf indication contraire, tous ce qui a été indiqué pour le dispositif 2 de la figure 3 s'applique au dispositif 2 de la figure 4. En figure 4, seule la puce 200 du dispositif 2 est représentée.

En particulier, le dispositif 2 de la figure 4 diffère de celui de la figure 3 en ce que :
- la puce 200 comprend un circuit de détection DET3 ; et
- le circuit CTRL' y est remplacé par un circuit CTRL".

Dans le dispositif 2 de la figure 3, le circuit CTRL' commute le transistor LS à l'état passant suite à une détection, par le circuit DET2, que la tension du noeud 114 est proche de la valeur nulle.

Toutefois, ce fonctionnement est acceptable si, lors de chaque commutation du transistor HS à l'état bloqué, la tension du noeud 114 diminue assez pour devenir proche de la valeur nulle et déclencher la commutation à l'état passant du transistor LS. A titre d'exemple, ce n'est pas le cas dans certaines applications où le courant circulant dans le transistor HS lors de sa commutation à l'état bloqué est trop faible et/ou une capacité parasite sur le noeud 114 est trop importante pour que la tension du noeud 114 deviennent proche de la valeur nulle.

Pour ces applications, il est alors prévu d'utiliser le dispositif 2 de la figure 4 dans lequel, par rapport au dispositif 2 de la figure 3 :
- le circuit CTRL' est remplacé par un circuit CTRL" ; et
- la puce 200 comprend en outre un circuit de détection DET3.

Le circuit DET3 est configuré pour détecter lorsque le transistor HS est à l'état bloqué.

Le circuit DET3 est configuré pour détecter que le courant dans le transistor HS devient inférieur à un seuil, le transistor HS étant considéré à l'état bloqué lorsque le courant dans le transistor HS est inférieur à ce seuil.

A titre d'exemple, le circuit DET3 fournit un signal binaire sig3 indiquant par un premier état binaire que le transistor HS est à l'état passant, c'est à dire par exemple que le courant circulant dans le transistor HS est supérieur au seuil mentionné ci-dessus, et par un deuxième état binaire que le transistor HS est à l'état bloqué, c'est à dire par exemple que le courant circulant dans le transistor HS est inférieur à ce seuil. Le signal sig3 est par exemple disponible sur une sortie 214 du circuit DET3.

A titre d'exemple, le circuit DET3 comprend une entrée 216 connectée à la grille du transistor HS, une entrée 218 connectée à la source du transistor HS, et une entrée 220 connectée au plot 108.

Le circuit de commande CTRL'' est, dans cet exemple, configuré comme le circuit CTRL' pour commander une commutation à l'état passant du transistor LS dès que le circuit DET2 détecte, après ou pendant une commutation à l'état bloqué du transistor HS, que la tension du noeud 114 est proche de la valeur nulle.

Toutefois, par rapport au circuit CTLR', le circuit CTRL" reçoit en outre du circuit DET3 une indication que le transistor HS est bloqué ou non. Par exemple, le circuit CTRL" reçoit le signal sig3.

Le circuit CTRL" est alors configuré pour commander une commutation à l'état passant du transistor LS dès que le circuit DET3 détecte, après ou pendant une commutation à l'état bloqué du transistor HS, que le transistor HS est bien à l'état bloqué. Dit autrement, dans cet exemple, dès que le circuit CTRL" reçoit une indication que la tension du noeud 114 est proche de la valeur nulle ou que la transistor HS est bien à l'état bloqué, le circuit CTRL" commande la commutation du transistor LS à l'état passant.

Ainsi, si à la suite d'une commutation à l'état bloqué du transistor HS, la tension du noeud 114 ne devient pas suffisamment proche de la valeur nulle pour que cela déclenche la commutation à l'état passant du transistor LS, cette commutation à l'état passant du transistor LS sera de toute façon déclenchée dès que le transistor HS sera bien à l'état bloqué.

Dans l'exemple de la figure 4, le circuit CTRL" commute le transistor LS à l'état passant dès qu'il reçoit l'indication que la tension du noeud 114 est proche de la valeur nulle ou l'indication que le transistor HS est bloqué.

Dans d'autres exemples, la puce 200 ne comprend pas le circuit DET2 et le circuit CTRL" est configuré pour commander la commutation à l'état passant du transistor LS uniquement lorsqu'il reçoit l'indication que le transistor HS est à l'état bloqué. Dans ces autres exemples, il est alors possible que la diode D se mette en conduction avant que le transistor LS ne soit passant, et les pertes seront alors plus élevées que dans l'exemple de la figure 3 ou 4.

De manière optionnelle, comme cela est représenté en figure 4, lorsque la puce 200 comprend le circuit DET3, le circuit HS-CTRL' peut être remplacé par un circuit HS-CTRL" qui reçoit non seulement l'indication que la résistance source-drain du transistor HS est supérieure à une valeur seuil, c'est à dire par exemple le signal sig1, mais aussi l'indication que le transistor HS est à l'état bloqué ou non, c'est à dire par exemple le signal sig3.

Dans ce cas, le circuit HS-CTRL" est configuré pour fournir le premier courant tant que le circuit DET3 détecte que le transistor HS est bloqué ou que le circuit DET1 ne détecte pas d'augmentation de la résistance drain-source du transistor HS. Ainsi, lors de chaque commutation du transistor HS à l'état bloqué, le circuit HS-CTRL" fournit le premier courant jusqu'à ce que le circuit DET1 détecte une augmentation de la valeur de la résistance drain-source du transistor HS alors que le transistor HS n'est pas encore bloqué. A partir de cet instant, le circuit HS-CTRL" fournit le deuxième courant jusqu'à ce que le circuit DET3 détecte que le transistor HS est à l'état bloqué. A partir de cet instant, le circuit HS-CTRL" fournit le premier courant.

Il en résulte que, lorsque le transistor HS est bloqué, la tension sur sa grille sera moins sensible à des variations de la tension du noeud 114 qui se propagent sur la grille du transistor HS par couplage capacitif, par rapport au cas où la grille du transistor recevrait encore le deuxième courant plus faible. Cela évite d'éventuelles mises à l'état passant du transistor HS qui ne seraient pas voulues.

A titre d'exemple, le fonctionnement décrit ci-dessus du circuit HS-CTRL'' correspond au fonctionnement du circuit HS-CTRL'' lorsque le signal sigHS commute à son premier état binaire, jusqu'à ce que le signal sigHS commute de nouveau à son deuxième état binaire.

Dans encore d'autres exemples, on peut prévoir une puce 200 comprenant les circuits DET1, DET2, DET3, CTRL' et HS-CTRL", ou encore une puce comprenant les circuits DET1, DET2, DET3, CTRL" et HS-CTRL'.

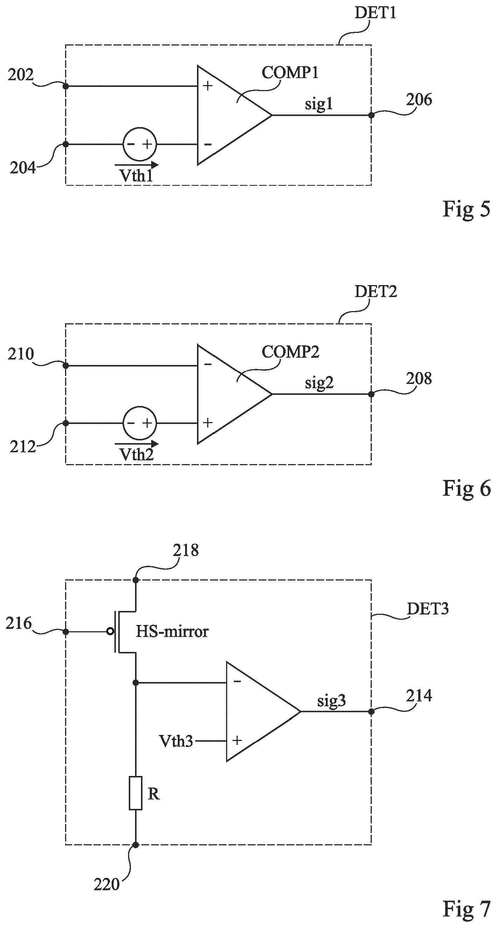

La figure 5 représente un exemple de mode de réalisation détaillé du circuit DET1 du dispositif 2 des figures 2, 3 et 4.

Dans cet exemple, le circuit DET1 comprend un comparateur COMP1. Le comparateur COMP1 est ici configuré pour comparer la tension de source du transistor HS avec une tension égale à la somme de la tension de drain du transistor HS et d'une tension de seuil Vth1. Dit autrement, le comparateur COMP1 est configuré pour comparée la tension de source du transistor HS à la tension de drain du transistor HS majorée par la tension Vth1. Dit encore autrement, le comparateur COMP1 est configuré pour comparée à la tension drain-source du transistor HS à la tension de seuil Vth1.

La tension Vth1 est, par exemple, déterminée, pour une valeur maximale de courant dans l'inductance LpHS au début de chaque commutation à l'état passant du transistor HS, par la valeur seuil de la résistance drain-source du transistor HS au-dessus de laquelle la résistance drain-source du transistor HS est considéré comme étant en train d'augmenter, c'est à dire par la valeur seuil de la résistance drain-source du transistor HS au-dessus de laquelle, lors d'une commutation à l'état bloqué du transistor HS, ce dernier est considéré comme étant dans la troisième phase de la commutation. Par exemple, la tension Vth1 est sensiblement égale à Imax*10*Rtarget, où Imax est la valeur maximale attendue pour le courant dans l'inductance LpHS au début d'une commutation à l'état bloqué du transistor HS, et Rtarget est la valeur de seuil de la résistance source-drain du transistor HS.

A titre d'exemple, le comparateur COMP1 a une entrée, par exemple non inverseuse (+), connectée à l'entrée 202 du circuit DET1, une entrée, par exemple inverseuse (-), couplée à l'entrée 204 du circuit DET1 et une sortie connectée à la sortie 206 du circuit DET1 et configuré pour fournir le signal sig1. A titre d'exemple, l'entrée du comparateur COMP1 qui est couplée au drain du transistor HS est couplée à l'entrée 204 du circuit DET1 par un générateur de tension apte à appliquer une différence de tension Vth1 entre l'entrée 204 et l'entrée du comparateur COMP1.

La figure 6 représente un exemple de mode de réalisation détaillé du circuit DET2 du dispositif 2 des figures 3 et 4.

Dans cet exemple, le circuit DET2 comprend un comparateur COMP2. Le comparateur COMP2 est ici configuré pour comparer la tension 114 avec une tension de seuil Vth2. A titre d'exemple, la tension Vth2 est la tension au-dessous de laquelle, lors d'une commutation à l'état bloqué du transistor HS, la tension du noeud 114 est considérée suffisamment proche de la valeur nulle. Dit autrement, le comparateur COMP2 est configuré pour comparer la tension du noeud 114 avec la tension du plot 108 majorée par la tension de seuil Vth2.

A titre d'exemple, le comparateur COMP2 a une entrée, par exemple inverseuse (-), connectée à l'entrée 210 du circuit DET2, une entrée, par exemple non inverseuse (+), couplée à l'entrée 212 du circuit DET2 et une sortie connectée à la sortie 208 du circuit DET2 et configuré pour fournir le signal sig2. A titre d'exemple, l'entrée du comparateur COMP2 qui est couplée au plot 108 est couplée à l'entrée 212 du circuit DET2 par un générateur de tension apte à appliquer une différence de tension Vth2 entre l'entrée 212 et l'entrée du comparateur COMP2.

La figure 7 représente un exemple de mode de réalisation détaillé du circuit DET3 du dispositif 2 de la figure 4.

Le circuit DET3 comprend un transistor PMOS HS-mirror monté en miroir du transistor HS. Dit autrement, le transistor HS-mirror a sa grille connectée à la grille du transistor HS (entrée 216 du circuit DET3), sa source connectée à la source du transistor HS, donc au plot 102 (entrée 218 du circuit DET3) et sont drain polarisé par une source de courant constant ou par une résistance R.

Dans l'exemple de la figure 7, le drain du transistor HS-mirror est polarisé par la résistance R, cette dernière étant connectée entre le drain du transistor HS-mirror et le plot 108 (entrée 220 du circuit DET3).

Le circuit DET3 comprend en outre un comparateur COMP3. Le comparateur COMP3 est configuré pour comparer la tension de drain du transistor HS-mirror avec une tension de seuil Vth3.

En effet, dans cet exemple, pour une valeur de résistance R donnée, la tension sur le drain du transistor HS-mirror est déterminée par le courant dans le transistor HS-mirror, donc dans le transistor HS avec lequel le transistor HS-mirror est monté en miroir. Ainsi, la valeur de la tension Vth3 est par exemple choisie de sorte que, lorsque la tension de drain du transistor est inférieure à la tension Vth3, cela signifie que le courant dans le transistor HS-mirror est nul ou presque, donc que le transistor HS-mirror est à l'état bloqué, le transistor HS étant alors lui aussi à l'état bloqué du fait que les transistors HS et HS-mirror sont en miroir l'un de l'autre.

Des exemples détaillés de mode de réalisation des circuits DET1, DET2 et DET3 ont été décrits ci-dessus en relation avec les figures 5, 6 et 7 respectivement. Toutefois, d'autres mises en œuvre de ces circuits apparaîtront à la personne du métier à partir des indications fonctionnelles données ci-dessus.

Par ailleurs, bien que la puce 200 ait été décrite pour l'exemple où le transistor HS, et le transistor LS lorsqu'il est présent, sont des interrupteurs respectivement de côté haut et de côté bas d'un convertisseur DC-DC abaisseur à découpage ("Buck DC-DC SMPS" en anglais), les modes de réalisation et variantes décrits s'appliquent à des puces 200 où le transistor HS, et le transistor LS lorsqu'il est présent, ne sont pas des interrupteurs de côté haut et de côté bas d'un convertisseur à découpage. En effet, la problématique de décharge de l'inductance parasite LpHS lors de la commutation à l'état bloqué du transistor HS couplant le plot 102 au noeud 114 se pose dans tous les dispositifs où le plot 102 est relié à une tension Vin par un fil 106 et où le dispositif pilote, avec des commutations de l'interrupteur HS, une charge couplée au noeud 114, cela étant d'autant plus vrai lorsque la charge pilotée comprend une inductance. C'est par exemple le cas d'un dispositif 2 pilotant une bobine de relai ou un moteur. Toutefois, dans ces applications de pilotage de bobine de relai ou de moteur, les fréquences de commutation de l'interrupteur HS sont généralement plus faibles que dans un convertisseur DC-DC à découpage. Ainsi, dans ces applications, il est généralement possible d'utiliser un même courant de commande de l'interrupteur HS pendant toute la durée des première, deuxième et troisième phase de chaque commutation à l'état bloqué de l'interrupteur HS en choisissant une valeur de ce courant de pilotage suffisamment faible pour permettre la décharge complète de l'inductance parasite LpHS avant la commutation effective de l'interrupteur HS à l'état bloqué. Cela n'est en revanche pas possible dans un convertisseur DC-DC à découpage.

Par ailleurs, lorsque le transistor LS est omis, la personne du métier comprendra que le circuit DET2 est omis.

Les modes de réalisation et variantes décrits ne se limitent pas aux exemples où la charge à laquelle est couplé le noeud 114 comprend une inductance Lext. Dans d'autres exemples, la charge peut ne pas comprendre d'inductance.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus. En particulier, pour ce qui est des circuits HS-CTRL' et HS-CTRL", leur mise en œuvre est à la portée de la personne du métier à partir des indications fonctionnelles données ci-dessus, de même que la mise en œuvre des circuits CTRL' et CTRL" est à la portée de la personne du métier à partir des indications fonctionnelles données ci-dessus.

## Revendications

1. Puce de circuit intégré (200) comprenant :
- un premier plot de connexion (102) destiné à être couplé à une tension d'alimentation externe (Vin) par un premier fil conducteur (106) ;
- un deuxième plot de connexion (108) destiné à être couplé à une tension de référence externe (GND) par un deuxième fil conducteur (112) ;
- un transistor PMOS (HS) couplant le premier plot (102) à un noeud interne (114) de la puce configuré pour être connecté à une charge (Lext) ;
- une capacité de découplage (C) couplant les premier et deuxième plots (102 ; 108) entre eux ;
- un premier circuit de détection (DET1) configuré pour détecter une augmentation, par exemple au-dessus d'un premier seuil (Vth1), d'une résistance source/drain du transistor PMOS ;
- un deuxième circuit de détection (DET3) configuré pour détecter que le transistor PMOS (HS) est à l'état bloqué en comparant un courant dans le transistor PMOS à un seuil de courant ; et
- un premier circuit de commande (HS-CTRL' ; HS-CTRL") configuré, lors de chaque commutation à l'état bloqué du transistor PMOS (HS), pour fournir un premier courant à la grille du transistor PMOS si le deuxième circuit de détection (DET3) détecte que le transistor PMOS est bloqué ou si le premier circuit de détection (DET1) ne détecte pas une augmentation de la résistance source/drain, et pour fournir un deuxième courant plus faible que le premier courant sinon.

2. Puce selon la revendication 1, dans laquelle la puce de circuit intégré (200) comprend en outre une diode (D) couplant le noeud interne (114) au deuxième plot (108), l'anode de la diode étant du côté du deuxième plot.

3. Puce selon la revendication 1 ou 2, dans laquelle le noeud interne (114) est couplé, de préférence connecté, à un troisième plot de connexion (116) de la puce, le troisième plot étant destiné à être connectée une inductance externe (Lext) par un troisième fil conducteur (118), l'inductance externe faisant partie de la charge.

4. Puce selon l'une quelconque des revendications 1 à 3, dans laquelle la puce de circuit intégré (200) comprend en outre un circuit (ESD) de protection contre les décharges électrostatiques couplant les premier et deuxième plots (102 ; 108) entre eux.

5. Puce selon l'une quelconque des revendications 1 à 4, dans laquelle le premier circuit de détection (DET1) comprend un comparateur (COMP1) configuré pour comparer la tension de source du transistor PMOS à la tension de drain du transistor PMOS majorée par une tension de seuil (Vth1) du premier circuit de détection, et pour fournir un signal binaire (sig1) indiquant un résultat de la comparaison.

6. Puce selon l'une quelconque des revendications 1 à 5, dans laquelle la puce de circuit intégré (200) comprend en outre un deuxième circuit de commande (CTRL' ; CTRL") configuré pour fournir un premier signal binaire (sigHS) au premier circuit de commande (HS-CTRL' ; HS-CTRL"), un premier état binaire du premier signal (sigHS) commandant l'état bloqué du transistor PMOS (HS) et un deuxième état binaire du premier signal (sigHS) commandant un état passant du transistor PMOS (HS).

7. Puce selon la revendication 6, dans laquelle la puce de circuit intégré (200) comprend en outre :
- un transistor NMOS (LS) couplant le noeud interne (114) au deuxième plot (108) ; et
- un troisième circuit de commande (LS-CTRL) configuré pour commander le transistor NMOS (LS),
le deuxième circuit de commande (CTRL' ; CTRL") étant configuré pour fournir un deuxième signal binaire (sigLS) au troisième circuit de commande (LS-CTRL), un premier état binaire du deuxième signal (sigLS) commandant l'état bloqué du transistor NMOS (LS) et un deuxième état binaire du deuxième signal (sigLS) commandant un état passant du transistor NMOS (LS).

8. Puce selon la revendication 7, dans laquelle :
- la puce de circuit intégré (200) comprend en outre un troisième circuit de détection (DET2) configuré pour détecter lorsqu'une tension du noeud interne (114) est proche d'une valeur nulle, par exemple en comparant ladite tension à un deuxième seuil (Vth2) ; et
- le deuxième circuit de commande (CTRL' ; CTRL") est configuré pour commuter le deuxième signal (sigLS) à son deuxième état binaire quand le troisième circuit de détection (DET2) détecte que la tension du noeud interne (114) est proche de la valeur nulle.

9. Puce selon la revendication 8, dans laquelle le troisième circuit de détection (DET2) comprend un comparateur (COMP2) configuré pour comparer la tension du noeud interne (114) à la tension du deuxième plot (108) majorée par une tension de seuil (Vth2) du troisième circuit de détection, et pour fournir un signal binaire (sig2) indiquant un résultat de la comparaison.

10. Puce selon la revendication 8 ou 9, dans laquelle le deuxième circuit de commande (CTRL") est configuré pour commuter le deuxième signal (sigLS) à son deuxième état binaire dès que le troisième circuit de détection (DET2) détecte que la tension du noeud interne (114) est proche de la valeur nulle ou que le deuxième circuit de détection (DET3) détecte que le transistor PMOS (HS) est à l'état bloqué.

11. Puce selon l'une quelconque des revendications 1 à 10, dans laquelle le deuxième circuit de détection (DET3) comprend :
un transistor PMOS (HS-mirror) supplémentaire monté en miroir du transistor PMOS (HS) et ayant son drain couplé au deuxième plot (108) par une résistance ou une source de courant constant ; et
un comparateur (COMP3) configuré pour comparer la tension de source du transistor PMOS supplémentaire (HS-mirror) à un seuil (Vth3) et pour fournir un signal binaire (sig3) indiquant le résultat de la comparaison.

12. Puce selon l'une quelconque des revendications 1 à 11, dans laquelle le transistor PMOS (HS) est un transistor de côté haut d'un convertisseur DC-DC à découpage.

13. Dispositif électronique (2), dans lequel le dispositif comprend :
- la puce de circuit intégré (200) selon l'une quelconque des revendications 1 à 12 ;
- une source de la tension d'alimentation (Vin) disposée à l'extérieur de la puce (200) et couplée au premier plot (102) de la puce par le premier fil conducteur (106) ;
- une source de la tension de référence (GND) disposée à l'extérieur de la puce (200) et couplée au deuxième plot (110) de la puce (200) par le deuxième fil conducteur (112).

## Patentansprüche

1. Integrierter Schaltkreis-Chip (200), der Folgendes aufweist:
- ein erstes Anschluss-Pad (102), vorgesehen zum Koppeln an eine externe Versorgungsspannung (Vin) durch einen ersten Leitungsdraht (106);
- ein zweites Anschluss-Pad (108), vorgesehen zum Koppeln an eine externe Referenzspannung (GND) durch einen zweiten Leitungsdraht (112);
- einen PMOS-Transistor (HS), der das erste Pad (102) mit einem internen Knoten (114) des Chips koppelt, der eingerichtet ist zum Verbinden mit einer Last (Lext);
- einen Entkopplungs-Kondensator (C), der das erste und das zweite Pad (102; 108) miteinander koppelt;
- eine erste Detektionsschaltung (DET1), eingerichtet zum Detektieren einer Erhöhung, zum Beispiel über einen ersten Schwellenwert (Vth1), eines Source/Drain-Widerstands des PMOS-Transistors;
- eine zweite Detektionsschaltung (DET3), eingerichtet zum Detektieren, dass der PMOS-Transistor (HS) in einem Aus-Zustand ist, durch Vergleichen eines Stroms in dem PMOS-Transistor mit einem Stromschwellenwert; und
- eine erste Steuerschaltung (HS-CTRL'; HS-CTRL"), eingerichtet, während jedes Schaltens des PMOS-Transistors (HS) in den Aus-Zustand, einen ersten Strom an das Gate des PMOS-Transistors zu liefern, wenn die zweite Detektionsschaltung (DET3) detektiert, dass der PMOS-Transistor (HS) in dem Aus-Zustand ist oder wenn die erste Detektionsschaltung (DET1) keine Erhöhung des Source/Drain-Widerstands detektiert, und ansonsten einen zweiten, kleineren Strom als den ersten Strom zu liefern.

2. Chip nach Anspruch 1, wobei der integrierte Schaltkreis-Chip (200) ferner eine Diode (D) aufweist, die den internen Knoten (114) mit dem zweiten Pad (108) koppelt, wobei die Anode der Diode auf der Seite des zweiten Pads angeordnet ist.

3. Chip nach Anspruch 1 oder 2, wobei der interne Knoten (114) mit einem dritten Anschluss-Pad (116) des Chips gekoppelt, vorzugsweise verbunden, ist, wobei das dritte Pad vorgesehen ist zum Verbinden mit einer externen Induktivität (Lext) durch einen dritten Leitungsdraht (118), wobei die externe Induktivität einen Teil der Last bildet.

4. Chip nach einem der Ansprüche 1 bis 3, wobei der integrierte Schaltkreis-Chip (200) ferner eine Schutzschaltung (ESD) gegen elektrostatische Entladungen aufweist, die das erste und das zweite Pad (102; 108) miteinander koppelt.

5. Chip nach einem der Ansprüche 1 bis 4, wobei die erste Detektionsschaltung (DET1) einen Komparator (COMP1) aufweist, der eingerichtet ist zum Vergleichen der Source-Spannung des PMOS-Transistors mit der Drain-Spannung des PMOS-Transistors, erhöht um eine Schwellenspannung (Vth1) der ersten Detektionsschaltung, und zum Bereitstellen eines binären Signals (sig1), welches ein Ergebnis des Vergleichs anzeigt.

6. Chip nach einem der Ansprüche 1 bis 5, wobei der integrierte Schaltkreis-Chip (200) ferner eine zweite Steuerschaltung (CTRL'; CTRL") aufweist, die eingerichtet ist zum Liefern eines ersten binären Signals (sigHS) an die erste Steuerschaltung (HS-CTRL'; HS-CTRL"), wobei ein erster binärer Zustand des ersten Signals (sigHS) den Aus-Zustand des PMOS-Transistors (HS) steuert und ein zweiter binärer Zustand des ersten Signals (sigHS) einen Ein-Zustand des PMOS-Transistors (HS) steuert.

7. Chip nach Anspruch 6, wobei der integrierte Schaltkreis-Chip (200) ferner Folgendes aufweist:
- einen NMOS-Transistor (LS), der den internen Knoten (114) mit dem zweiten Pad (108) koppelt; und
- eine dritte Steuerschaltung (LS-CTRL), die eingerichtet ist zum Steuern des NMOS-Transistors (LS),
wobei die zweite Steuerschaltung (CTRL'; CTRL") eingerichtet ist zum Liefern eines zweiten binären Signals (sigLS) an die dritte Steuerschaltung (LS-CTRL), wobei ein erster binärer Zustand des zweiten Signals (sigLS) den Aus-Zustand des NMOS-Transistors (LS) steuert und ein zweiter binärer Zustand des zweiten Signals (sigLS) einen Ein-Zustand des NMOS-Transistors (LS) steuert.

8. Chip nach Anspruch 7, wobei:
- der integrierte Schaltkreis-Chip (200) ferner eine dritte Detektionsschaltung (DET2) aufweist, die eingerichtet ist zum Detektieren, wenn eine Spannung des internen Knotens (114) nahe einem Nullwert ist, zum Beispiel durch Vergleichen der genannten Spannung mit einem zweiten Schwellenwert (Vth2); und
- die zweite Steuerschaltung (CTRL'; CTRL") eingerichtet ist zum Umschalten des zweiten Signals (sigLS) in seinen zweiten binären Zustand, wenn die dritte Detektionsschaltung (DET2) detektiert, dass die Spannung des internen Knotens (114) nahe dem Nullwert ist.

9. Chip nach Anspruch 8, wobei die dritte Detektionsschaltung (DET2) einen Komparator (COMP2) aufweist, der eingerichtet ist zum Vergleichen der Spannung des internen Knotens (114) mit der Spannung des zweiten Pads (108), erhöht um eine Schwellenspannung (Vth2) der dritten Detektionsschaltung, und zum Bereitstellen eines binären Signals (sig2), welches ein Ergebnis des Vergleichs anzeigt.

10. Chip nach Anspruch 8 oder 9, wobei die zweite Steuerschaltung (CTRL") eingerichtet ist zum Umschalten des zweiten Signals (sigLS) in seinen zweiten binären Zustand, sobald die dritte Detektionsschaltung (DET2) detektiert, dass die Spannung des internen Knotens (114) nahe Null ist, oder die zweite Detektionsschaltung (DET3) detektiert, dass der PMOS-Transistor (HS) in dem Aus-Zustand ist.

11. Chip nach einem der Ansprüche 1 bis 10, wobei die zweite Detektionsschaltung (DET3) Folgendes aufweist:
einen zusätzlichen PMOS-Transistor (HS-mirror), der als Spiegel mit dem PMOS-Transistor (HS) verbunden ist und dessen Drain mit dem zweiten Pad (108) durch einen Widerstand oder eine Konstantstromquelle gekoppelt ist; und
einen Komparator (COMP3), der eingerichtet ist zum Vergleichen der Source-Spannung des zusätzlichen PMOS-Transistors (HS-mirror) mit einem Schwellenwert (Vth3) und zum Bereitstellen eines binären Signals (sig3), welches das Ergebnis des Vergleichs anzeigt.

12. Chip nach einem der Ansprüche 1 bis 11, wobei der PMOS-Transistor (HS) ein High-Side-Transistor eines DC-DC-Schaltmoden-Netzteils ist.

13. Elektronische Vorrichtung (2), wobei die Vorrichtung Folgendes aufweist:
- den integrierten Schaltkreis-Chip (200) nach einem der Ansprüche 1 bis 12;
- eine Quelle der Versorgungsspannung (Vin), die außerhalb des Chips (200) angeordnet und mit dem ersten Pad (102) des Chips durch den ersten Leitungsdraht (106) gekoppelt ist;
- eine Quelle der Referenzspannung (GND), die außerhalb des Chips (200) angeordnet und mit dem zweiten Pad (110) des Chips (200) durch den zweiten Leitungsdraht (112) gekoppelt ist.

## Claims

1. Integrated circuit chip (200) comprising:
- a first connection pad (102) intended to be coupled to an external supply voltage (Vin) by a first conductive wire (106);
- a second connection pad (108) intended to be coupled to an external reference voltage (GND) by a second conductive wire (112);
- a PMOS transistor (HS) coupling the first pad (102) to an internal node (114) of the chip configured to be connected to a load (Lext);
- a decoupling capacitor (C) coupling the first and second pads (102; 108) together;
- a first detection circuit (DET1) configured to detect an increase, for example above a first threshold (Vth1), in a source/drain resistance of the PMOS transistor;
- a second detection circuit (DET3) configured to detect that the PMOS transistor (HS) is in the off state by comparing a current in the PMOS transistor to a current threshold; and
- a first control circuit (HS-CTRL' ; HS-CTRL") configured, during each switching of the PMOS transistor (HS) to the off state, to supply a first current to the gate of the PMOS transistor when the second detection circuit (DET3) detects that the PMOS transistor (HS) is in the off state or when the first detection circuit (DET1) does not detect an increase in the source/drain resistance, and to supply a second current lower than the first current otherwise.

2. Chip according to claim 1, wherein the integrated circuit chip (200) further comprises a diode (D) coupling the internal node (114) to the second pad (108), the anode of the diode being on the side of the second pad.

3. Chip according to claim 1 or 2, in which the internal node (114) is coupled, preferably connected, to a third connection pad (116) of the chip, the third pad being intended to be connected to an external inductor (Lext) by a third conductive wire (118), the external inductor forming part of the load.

4. Chip according to any one of claims 1 to 3, wherein the integrated circuit chip (200) further comprises a protection circuit (ESD) against electrostatic discharges coupling the first and second pads (102; 108) together.

5. Chip according to any one of claims 1 to 4, wherein the first detection circuit (DET1) comprises a comparator (COMP1) configured to compare the source voltage of the PMOS transistor with the drain voltage of the PMOS transistor increased by a threshold voltage (Vth1) of the first detection circuit, and to provide a binary signal (sig1) indicating a result of the comparison.

6. Chip according to any one of claims 1 to 5, wherein the integrated circuit chip (200) further comprises a second control circuit (CTRL'; CTRL") configured to supply a first binary signal (sigHS) to the first control circuit (HS-CTRL'; HS-CTRL"), a first binary state of the first signal (sigHS) controlling the off state of the PMOS transistor (HS) and a second binary state of the first signal (sigHS) controlling an on state of the PMOS transistor (HS).

7. Chip according to claim 6, wherein the integrated circuit chip (200) further comprises:
- an NMOS transistor (LS) coupling the internal node (114) to the second pad (108); and
- a third control circuit (LS-CTRL) configured to control the NMOS transistor (LS),
the second control circuit (CTRL' ; CTRL") being configured to supply a second binary signal (sigLS) to the third control circuit (LS-CTRL), a first binary state of the second signal (sigLS) controlling the off state of the NMOS transistor (LS) and a second binary state of the second signal (sigLS) controlling an on state of the NMOS transistor (LS).

8. Chip according to claim 7, wherein:
- the integrated circuit chip (200) further comprises a third detection circuit (DET2) configured to detect when a voltage of the internal node (114) is close to a null value, for example by comparing said voltage with a second threshold (Vth2); and
- the second control circuit (CTRL'; CTRL") is configured to switch the second signal (sigLS) to its second binary state when the third detection circuit (DET2) detects that the voltage of the internal node (114) is close to the null value.

9. Chip according to claim 8, wherein the third detection circuit (DET2) comprises a comparator (COMP2) configured to compare the voltage of the internal node (114) with the voltage of the second pad (108) increased by a threshold voltage (Vth2) of the third detection circuit, and to provide a binary signal (sig2) indicating a result of the comparison.

10. Chip according to claim 8 or 9, wherein the second control circuit (CTRL") is configured to switch the second signal (sigLS) to its second binary state as soon as the third detection circuit (DET2) detects that the voltage of the internal node (114) is close to zero or the second detection circuit (DET3) detects that the PMOS transistor (HS) is in the off state.

11. Chip according to any one of claims 1 to 10, wherein the second detection circuit (DET3) comprises:
an additional PMOS transistor (HS-mirror) mirror connected with the PMOS transistor (HS) and having its drain coupled to the second pad (108) by a resistor or constant current source; and
a comparator (COMP3) configured to compare the source voltage of the additional PMOS transistor (HS-mirror) to a threshold (Vth3) and to provide a binary signal (sig3) indicating the result of the comparison.

12. Chip according to any one of claims 1 to 11, wherein the PMOS transistor (HS) is a high-side transistor of a DC-DC switched mode power supply.

13. Electronic device (2), wherein the device comprises:
- the integrated circuit chip (200) according to any one of claims 1 to 12;
- a source of the supply voltage (Vin) disposed outside the chip (200) and coupled to the first pad (102) of the chip by the first lead wire (106);
- a source of the reference voltage (GND) disposed outside the chip (200) and coupled to the second pad (110) of the chip (200) by the second lead wire (112) .
